Europäisches Patentamt

European Patent Office

Office européen des brevets

(19)

(11) **EP 1 045 522 A1**

(12) **EUROPEAN PATENT APPLICATION**

(43) Date of publication:
**18.10.2000 Bulletin 2000/42**

(51) Int Cl.⁷: **H03M 13/27**

(21) Application number: **00400952.8**

(22) Date of filing: **06.04.2000**

| (84) Designated Contracting States:<br>**AT BE CH CY DE DK ES FI FR GB GR IE IT LI LU MC NL PT SE**<br>Designated Extension States:<br>**AL LT LV MK RO SI** | (71) Applicant: **Mitsubishi Electric Telecom Europe**<br>**92000 Nanterre (FR)** |
| --- | --- |
| (30) Priority: **07.04.1999 FR 9904340**<br>**21.04.1999 FR 9905048**<br>**18.06.1999 FR 9907774** | (72) Inventor: **Belaiche, Vincent Antoine Victor**<br>**35500 Vitre (FR)** |
| | (74) Representative: **Blot, Philippe Robert Emile et al**<br>**c/o Cabinet Lavoix,**<br>**2, place d'Estienne d'Orves**<br>**75441 Paris Cedex 09 (FR)** |

(54) **Method and device for channel interleaving and multiplexing**

(57)    The invention proposes a method and a device for interleaving and multiplexing data conveyed by several transport channels distributed into groups of transport channels (100). The transport channels (100) of one and the same group all have the same quality of service. The data of the transport channels of one and the same group are processed by one and the same processing chain (103A, 103B) specific to the group of transport channels. Each processing chain (103A, 103B) comprises at least one data interleaving step (154). A multiplexing step (152) is provided at the output of the processing chains (103A, 103B). The multiplexing step (152) on exit from the processing chains (103A, 103B) is a multiplexing by shuffling, and all the data interleaving steps (154) are performed within the processing chains (103A, 103B), before the said multiplexing step (152).

FIG.7

EP 1 045 522 A1

**Description**

The present invention relates to a method for interleaving and multiplexing data conveyed within several transport channels distributed into groups of transport channels, the transport channels of one and the same group all having the same quality of service, in which method the data of the transport channels of one and the same group are processed using one and the same processing procedure specific to the group of transport channels, each processing procedure comprising at least one data interleaving step, and in which a multiplexing step is provided at the conclusion of the processing procedures.

It relates in particular to a channel interleaver and a multiplexer of several transport channels for a system such as the one currently undergoing specification by the 3GPP project (3rd Generation Partnership Project).

A channel interleaver is a device placed between the channel coder (respectively decoder) and the transmission channel. The object of the channel coder/decoder is to counter the effects of interference. The object of the channel interleaver is to temporally space apart consecutive symbols on exit from the channel coder (respectively on entry to the decoder). Hence, a flaw impairing several consecutive symbols on the channel, impairs non-consecutive symbols on entry to the channel decoder, thus avoiding saturation of the latter. The sought-after effect is referred to as the time diversity gain. When this effect is achieved by interleaving, we speak of interleaving gain.

The 3GPP group is an association whose members originate from several regional standardization bodies including in particular the ETSI (European Telecommunication Standardization Institute) and the ARIB (Association of Radio Industries and Businesses). Its object is the standardization of a third-generation telecommunication system for mobiles. One of the fundamental aspects distinguishing third-generation from second-generation systems is that, apart from the fact that they will use the radio spectrum more efficiently, they will allow very great flexibility of service. Second-generation systems offer an optimized radio interface for certain services. For example GSM (Global System for Mobiles) is optimized for the transmission of speech (telephony). Third-generation systems will offer a radio interface adapted for All kinds of services and combinations of services. A problem which then arises is that of multiplexing the services without impairing the time diversity gain afforded by the channel interleaver.

One of the issues at stake with third-generation mobile radio systems is that of efficiently multiplexing, on the radio interface, services which do not have the same demands in terms of quality of service. Quality of service is defined, conventionally, by at least one criterion comprising in particular a processing delay, a bit error rate and/or an error rate in respect of a transport block.

The differences in quality of service imply respective transport channels having different tolerances to delays, and hence different channel interleavings, as well as, in the CDMA (Code Division Multiple Access) system envisaged in the 3GPP proposal, different rate matching.

In the OSI model (Open System Interconnection) from the ISO (International Standardization Organization), a telecommunication equipement is modelled by a layered model constituting a stack of protocols where each level is a protocol offering a service to the level above. Level 1 is in particular responsible for implementing channel coding and channel interleaving. The service offered by level 1 is referred to as "transport channels". A transport channel allows the upper level to transmit data with a certain quality of service. The quality of service is in particular characterized by the delay and the BER (Bit Error Rate). Since an interleaver brings about a delay which constitutes its time span, transport channels having different sensitivities to delays may require different interleavers for each transport channel.

The known solutions, and in particular those proposed in the 3GPP project, will be described with regard to the first few drawings in which:

Figure 1 is a diagrammatic view illustrating a rectangular interleaver;
Figure 2 is a diagrammatic view illustrating an incomplete generalized rectangular interleaver;
Figure 3 is a diagrammatic view illustrating the multiplexing of the transport channels on the uplink in the current 3GPP proposal;
Figure 4 is a diagrammatic view illustrating the multiplexing of the transport channels on the downlink in the current 3GPP proposal;
Figure 5 is a diagrammatic view illustrating multiplexing by concatenation;
Figure 6 is a diagrammatic view illustrating the destructive effect of multiplexing by concatenation on the interleaving gain.

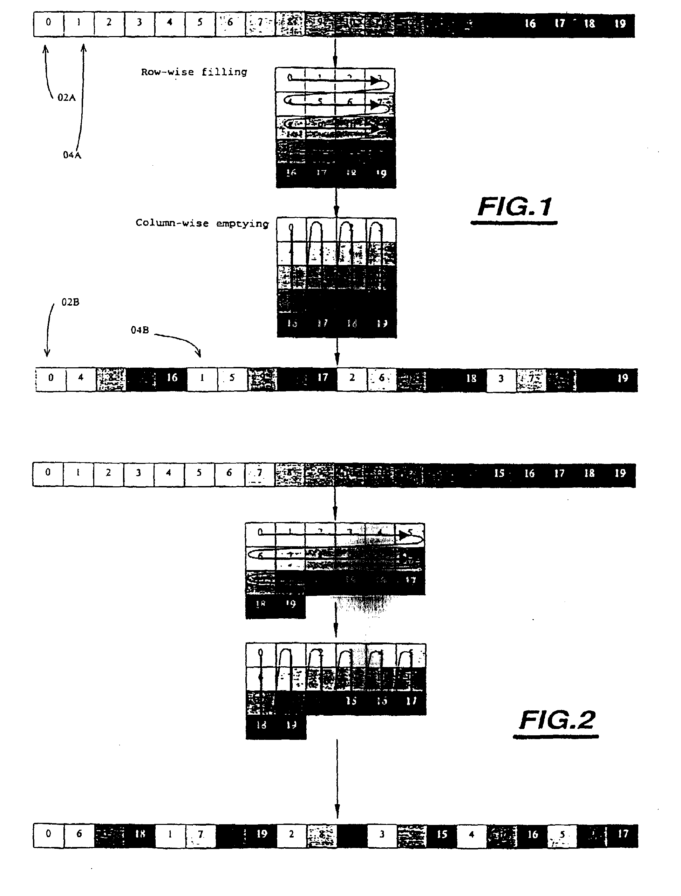

By way of example, a rectangular interleaver is represented in Figure 1. This rectangular interleaver operates as follows: 20 symbols being available for transmission, they are written into a memory space constituting a matrix with 4 columns and 5 rows. Writing is done row-wise. Thereafter, the symbols are read column-wise and transmitted in the order of reading. The number of symbols, 20 in this instance, being interleaved in this way is referred to as the depth of the interleaver. The following time diversity is noted: the symbols 0 and 1, respectively denoted by the references 02A and 04A, and which are consecutive before interleaving, are spaced apart after interleaving. They are then denoted by the references 02B and 04B.

It will be understood that, for the interleaver to operate, it is necessary to wait for 20 symbols to be available, hence the delay introduced by the interleaver.

As illustrated in Figure 2, it is possible to construct generalized rectangular interleavers, in which it is not necessary for the number of columns to be a divisor of the depth.

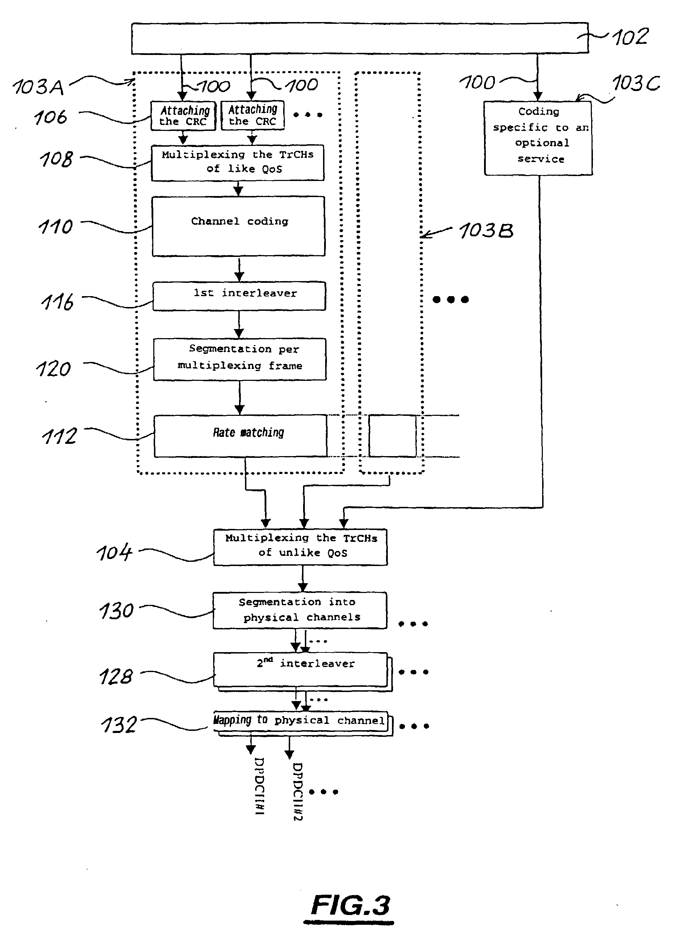

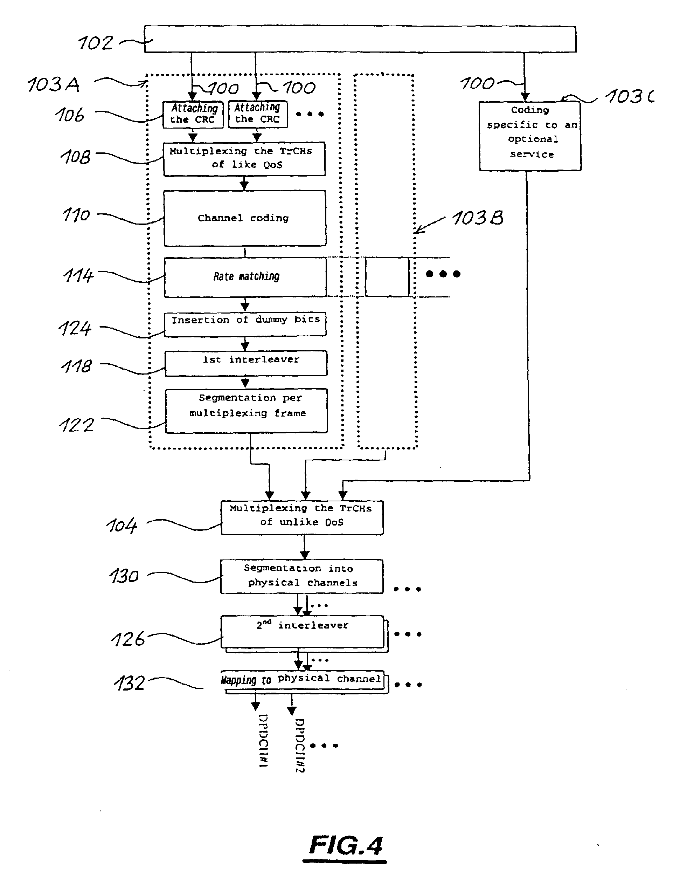

Represented in Figures 3 and 4 are the block diagrams for interleaving and multiplexing as defined by the current proposal by the 3GPP group, although this proposal has not yet been finalized.

In these figures, similar blocks bear the same numbers. In both cases the uplink (from the mobile station to the network) may be distinguished from the downlink (from the network to the mobile station), and only the transmission part is represented.

Each transport channel, labelled 100, periodically receives a set of transport blocks from an upper level, labelled 102. The number of transport blocks 100 in this set, as well as their sizes, depend on the nature of the transport channel. The minimum period at which the set of transport blocks is supplied corresponds to the time span of the interleaving of the transport channel. The transport channels with one and the same quality of service (QoS) are processed by one and the same processing chain 103A, 103B.

In each of the processing chains 103A, 103B, the transport channels, in particular after channel coding and channel interleaving, are multiplexed together by concatenation in step 104. This multiplexing is carried out per multiplexing frame. A multiplexing frame is the smallest unit of data for which demultiplexing may be carried out at least partially. A multiplexing frame typically corresponds to a radio frame. The radio frames form consecutive time intervals synchronized with the network, and numbered by the network. In the proposal by the 3GPP group, a radio frame corresponds to a duration of 10 ms.

The 3GPP proposal comprises the service-specific coding and interleaving option represented diagrammatically at 103C. The possibility of such an option is being considered at present since its indispensibility or otherwise has not yet been determined.

In the general case, a processing chain 103A firstly comprises a step 106 during which a bit word termed the FCS (Frame Check Sequence) is attached to each transport block. The bit word FCS is typically calculated by the so-called CRC technique (Cyclic Redundancy Check) which consists in considering the bits of the transport block to be the coefficients of a polynomial P and in calculating the CRC from the remainder of the polynomial (P+P0) after dividing by a so-called generating polynomial G, where P0 is a predefined polynomial for a given degree of P. The attaching of the bit word FCS is optional, and certain transport channels do not include this step. The exact technique for calculating the bit word FCS also depends on the transport channel, and especially on the maximum size of the transport blocks. The usefulness of the bit word FCS is to detect whether the transport block received is valid or corrupted.

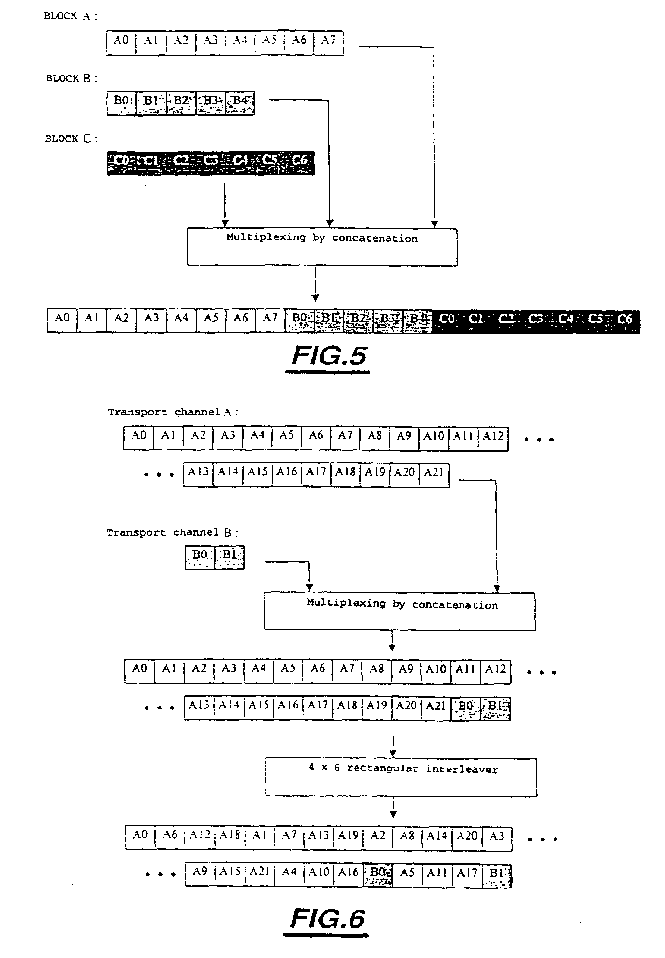

The next step 108 consists in multiplexing together the transport channels (TrCH) of like quality of service (QoS). This is because those transport channels which have the same quality of service may use the same channel coding. Typically, the multiplexing at 108 is carried out by concatenating the sets of transport blocks with their bit word FCS for each transport channel. An example of multiplexing by concatenation is given in Figure 5.

The next step, labelled 110, consists in performing the channel coding.

On exit from the channel coder 110 there is a set of coded blocks. Typically, in the case of a convolutional code, we have either zero or a single coded block of variable length. The length is given by the formula:

$$N_{output} = N_{input}/(\text{coding rate}) + N_{tail} \text{ (length of the coded block).}$$

with:

- $N_{output}$ = number of bits at output (length of the coded block);
- $N_{input}$ = number of bits at input;
- coding rate = constant ratio; and
- $N_{tail}$ = fixed quantity of information, independent of $N_{input}$, serving to empty the channel decoder properly at the time the coded block is received.

It is onwards of this step 110 that the uplink differs from the downlink, and that the invention differs from the current 3GPP proposal, as will be described hereinafter.

In each transport channel, whether the uplink (Figure 3) or the downlink (Figure 4), a rate matching step is implemented after the channel coding step 110. This step is labelled 112 for the uplink and 114 for the downlink. Rate matching is not necessarily performed immediately after channel coding 110.

The objective of the rate matching step 112 or 114 is to balance the ratio Eb/I between the transport channels with different qualities of service. The ratio Eb/I gives the average energy of a bit with respect to the interference. In a system using multiple access CDMA technology, the greater this ratio the greater is the quality which may be obtained. It will be understood therefore that transport channels having different qualities of service do not have the same need in terms of Eb/I, and that in the absence of rate matching, certain transport channels would have "too" good a quality of service relative to their respective needs, fixed as it is by the most demanding channel in terms of quality of service. Such transport channels would then needlessly cause interference. Rate matching therefore has a role of balancing Eb/I. Rate matching is such that X bits at input give Y bits at output, thus multiplying Eb/I by the ratio Y/X, hence the balancing capability. In what follows, the ratio Y/X is referred to as the rate matching ratio, also known as the rate matching ratio.

Rate matching is not done in the same way in the uplink and in the downlink.

This is because, in the uplink, it has been decided to transmit continuously, since discontinuous transmission worsens the peak/average ratio of the radio-frequency power at the output of the mobile station. The closer this ratio is to 1 the better. This is because, if this ratio is worsened (that is to say increased), this signifies that the power amplifier requires a greater margin (backoff) of linearity with respect to the mean operating point. On account of such a margin, the power amplifier would be less effective and would therefore consume more for the same average power emitted, and this would in particular unacceptably reduce the mobile station's battery-powered endurance. Because it is necessary to transmit continuously on the uplink, the rate matching ratio Y/X cannot be constant. This is because the sum $Y_1+Y_2+...Y_k$ of the numbers of bits after rate maching must be equal to the total number of bits in the radio frame for the data. This number may take only certain predefined values $N_1$, $N_2$, ..., $N_p$. It is therefore appropriate to solve the following system in k unknowns $Y_1$, ..., $Y_k$:

$$\begin{cases} \forall i \in \{1,\ldots,k\}\ Y_i = \lambda \cdot (Eb_i / I) \cdot X_i \\ Y_1 + \cdots + Y_k = N_j \\ \forall i \in \{1,\ldots,k\}\ \lambda \geq \dfrac{1 - P_i}{Eb_i / I} \end{cases}$$

where $X_i$ and $Eb_i/I$ and $P_i$ are characteristic constants of each transport channel, and where it is sought to minimize $N_j$ from among the p possible values $N_1$, $N_2$, ..., $N_p$ (note: $P_i$ is the maximum allowable puncture rate for a coded transport channel).

Thus, in the uplink, the rate matching ratios Y/X for each transport channel are not constant from one multiplexing frame to the next, but are defined to within a multiplicative constant: the pairwise ratios between these ratios therefore remain constant.

In the downlink, the peak/average ratio of the radio-frequency power is in any case very poor since the network transmits to several users simultaneously. The signals destined for these users combine constructively or destructively, thereby inducing wide variations in radio-frequency power emitted by the network, and hence a poor peak/average ratio. It was therefore decided that for the downlink the balancing of Eb/I between the various transport channels would be done with a rate matching having a constant rate matching ratio Y/X, and that the multiplexing frames would be supplemented with dummy bits, that is to say bits which are not transmitted, that is to say discontinuous transmission.

Thus, the difference between the uplink and the downlink lies in the fact that in the uplink the rate matching 112 is dynamic so as to supplement the multiplexing frames, whereas in the downlink the rate matching 114 is static and the multiplexing frames are supplemented through the insertion of dummy bits in the immediately following step 124.

The rate matching, whether dynamic or static, is done either by repetition or by bit-puncturing, according to an algorithm which was proposed to the ETSI by the Siemens company (registered trade mark) in the technical document referenced SMG2/UMTS-L1/Tdoc428/98. This algorithm makes it possible to obtain non-integer puncture/repetition ratios, and it is given in Table 1 for information.

```
Input data:
    X_i                     - number of bits at input
    Y_i                     - number of bits at output
    N_pr= |Y_i-X_i|         - number of bits to be repeated or
                              to be punctured (if Y_i>X_i we
                              repeat, otherwise we puncture)


The puncturing/repetition rule is as follows:
    e = 2*N_p/r-X_i         -- initial error between the current
                              and desired puncture/repetition ratios
    x = 0                   -- index of the current bit
    while x<X_i do
            if e > 0 then   -- test whether bit number x
                should be repeated/punctured

                puncture or repeat bit number x
                e = e + (2*N_p/r - 2* X_i) --   update       the
                                              error
            else
                    e = e + 2*N_p/r           --   update       the
                                              error
            end_if
            x = x + 1       --next bit
    end_do
```

Table 1 Repetition or puncturing algorithm

The particular feature of this algorithm is that, when it operates in puncture mode, it avoids the puncturing of consecutive bits, but on the contrary tends to maximize the spacing between two punctured bits. As far as repetition is concerned, the repetition bits follow the bits which they repeat. Under these conditions, it will be understood that it is beneficial for the rate matching to be done before interleaving. This is because, in respect of repetition, the fact that an interleaving follows the rate matching makes it possible to space the repeated bits apart. In respect of puncturing, the fact that an interleaver precedes the rate matching gives rise to the risk that the rate matching might puncture consecutive bits on exit from the channel coder. A catastrophic case would be a rectangular interleaver between the channel coder and the rate matching, this interleaver having a number of rows equal to the puncture period. In this case, all the punctured bits would be consecutive on exit from the channel coder. It is therefore advantageous for the rate matching to be done as high up as possible, that is to say as near as possible to the channel coder.

Moreover, each processing chain 103A, 103B also comprises, after the channel coding step 110, a first interleaver labelled 116 for the uplink and 118 for the downlink, followed by a step of segmentation per multiplexing frame, labelled 120 for the uplink and 122 for the downlink. The first interleaver 118 is not necessarily located immediately after the channel coding 110.

For the downlink, it is possible to place the rate matching 114 right at the output of the channel coding 110, since the rate matching ratio is constant. Hence, a priori only a single interleaver 118 is needed. However, it will be seen later that in the case of the 3GPP proposal, a second interleaver 126 is necessary after the multiplexing 104.

For the uplink, the rate matching ratio may vary with each multiplexing frame, this explaining the need for at least the first interleaver 116 before the rate matching 112 so as to distribute the bits of the coded block over several multiplexing frames, and for a second interleaver 128 placed after the rate matching 112 so as to space apart the bits repeated by the rate matching 112.

Thus, in the block diagrams of Figures 3 and 4 may be seen two interleavers referred to in the block diagrams as the first and second interleavers. The first interleaver 116, 118 is an interleaver the time span of which is equal to the interleaving time span for the corresponding transport channel. This span may be longer than the duration of a multiplexing frame and is typically a multiple thereof in a constant ratio. This is why this first interleaver 116, 118 is also sometimes referred to as an inter-frame interleaver.

The second interleaver 126, 128 is also referred to as an intra-frame interleaver since its time span is that of a multiplexing frame.

Consequently, the step of segmentation per multiplexing frame labelled 120, 122 is situated between the first 116, 118 and the second 128, 126 interleavers (when there is a second interleaver). This step consists in segmenting the blocks which are coded and are interleaved by the first interleaver 116, 118 into as many segments as is equal to the ratio of the time span of the first interleaver to the duration of a multiplexing frame. This segmentation is typically done in such a way that the concatenation of the segments once again yields the interleaved coded block.

It will be noted that, in the uplink, this segmentation step 120 is necessarily located before the rate matching 112. This is because the rate matching 112 is done according to a ratio established dynamically multiplexing frame by multiplexing frame, and it is not therefore possible to do it on a unit of data which may extend over several multiplexing frames.

In the uplink and the downlink, a step 130 of segmentation into physical channels is implemented before each second interleaver 126, 128. Likewise, the second interleavers 126, 128 are followed by a step 132 of mapping to physical channel for transmission proper.

In general, it is not desirable to have two interleavers in series. This is because, firstly in the case of a single transport channel, there is no need for this since, once the interleaving has been carried out there is no longer any time diversity gain to be expected. Thus, rather have a single well optimized interleaver.

Moreover, if there are two interleavers in series, it is not possible to define them independently. This is because there is a risk that the good time diversity properties acquired by the first interleaver 116 may be destroyed by the second interleaver 128.

Now, in the case of the 3GPP proposal, it will be observed that there are two interleavers in series (118 and 126 in the downlink, 116 and 128 in the uplink). Moreover, a second interleaver is placed after the multiplexing 104 of the transport channels. The transport channels being independent of each other, it is impossible to determine in advance which indices will be those of the bits corresponding to a transport channel on reaching the second interleaver 126, 128, and it is therefore impossible to ascertain how the transport channel will be interleaved. There is therefore a risk that the combination of the first 116, 118 and of the second 126, 128 interleavers may have a destructive effect on the time diversity gain, and there is also a risk that this time diversity gain will be further impaired on account of the multiplexing 104.

Let us thus take the example of two transport channels having very different bit rates, a transport channel A and a transport channel B, and let us assume for simplicity that the second interleaver is a rectangular interleaver. An example is given in Figure 6. The two symbols of B are 4 symbols apart in the multiplexing frame, whereas this frame being 24 symbols, they could be 12 symbols apart, i.e. 3 times further apart.

Of course, the example of Figure 6 is somewhat exaggerated. In fact, the second interleaver is an MIL interleaver (Multistage InterLeaver) which is more complex than a simple rectangular interleaver, and the effect shown in Figure 6 would not be as great. However, this interleaver is static, it is defined by a table which is fixed once and for all and it cannot therefore be optimal for all cases of multiplexing.

Solutions to this problem have already been envisaged.

A first state of the art solution consists in providing a first complex interleaver and a second simple interleaver. However, in the uplink, the rate matching being placed after the first complex interleaver, for high puncture rates, the first interleaver and the rate matching cooperate with difficulty.

According to a second prior art solution, the first interleaver is simple and the second interleaver is complex. It is then difficult for the second interleaver to have dynamically variable depth, that is to say which varies multiplexing frame by multiplexing frame, this being made necessary in respect of the grouping together of untransmitted dummy bits.

The objective of the invention is to ensure that the time-division multiplexing of the various transport channels, as well as their rate matching, do not impair the time diversity gain afforded by the channel interleaving without giving rise to the accompanying problems of the state of the art solutions.

To this end, the subject of the invention is a method characterized in that the said multiplexing step on exiting the said processing procedures is a multiplexing by shuffling, and in that all the said data interleaving steps are implemented within the said processing procedures.

As a variant, the method comprises one or more of the following characteristics:

- each processing procedure implements first and second interleaving steps operating in succession;
- the said second interleaving step comprises a rectangular interleaving step with dynamically variable depth;
- a single rate matching step is provided within each processing procedure between the said first and second interleaving steps;
- the said first interleaving step comprises an initial step of writing symbols along the rows of a matrix, the number of columns of which is equal to the number of multiplexing frames which can be processed during the said step of multiplexing by shuffling in the time span necessary for the said first interleaving step, and a subsequent step of reading symbols along the columns of the matrix for obtaining blocks of interleaved symbols, and the blocks of interleaved symbols obtained following the implementation of the said first interleaving step are segmented so that each segment corresponds to a column of the said matrix, the said rate matching step being implemented on each of the said segments;
- it comprises a single interleaving step in each processing procedure;
- it comprises, after the said step of multiplexing by shuffling, a step of inserting dummy bits;
- a rate matching step is implemented for each processing procedure, with a static rate matching ratio;
- the said step of multiplexing by shuffling initially comprises a step consisting in associating, with each block to be multiplexed, a variable obtained by applying a first evaluation criterion, then, for the construction of the multiplex, the following steps, repeated iteratively for all the symbols to be multiplexed:

  a) selecting, as a function of a second evaluation criterion pertaining to the said associated variables, one of the blocks to be multiplexed;
  b) extracting from the selected block the next remaining symbol when considering a given order of reading in the selected block;
  c) inserting the extracted symbol at the end of the multiplex; and
  d) re-updating the variable associated with the selected block;

- the said step of multiplexing by shuffling is implemented on data blocks the number and size of which vary dynamically from one multiplexing frame to the next; and
- it is implemented within a radio-communication system implementing CDMA technology.

The subject of the invention is moreover a device for interleaving and multiplexing data conveyed within several transport channels distributed into groups of transport channels, the transport channels of one and the same group all having the same quality of service, comprising:

- a processing chain specific to each group of transport channels, allowing the processing of the data of the transport channels of one and the same group, each processing chain comprising at least data interleaving means, and
- multiplexing means provided at the output of the processing chains,

characterized in that the multiplexing means provided at the output of the processing chains are means of multiplexing by shuffling, and in that all the data interleaving means are included within the processing chains.

As a variant, the said means of multiplexing by shuffling comprise a hardware accelerator making it possible to perform a sort of a set of pairs of values comprising, for each of the said pairs, at least:

- an identification value for a class of data blocks having an identical size of data blocks; and
- an error value associated with each class of data blocks, the said error value making it possible to select, iteratively, from among the classes of data blocks to be multiplexed, the class of data blocks the symbols of which are to be appended to the multiplex undergoing formation;

the said hardware accelerator comprising:

- loading means for the said pairs of values, the said loading means making it possible to load into the input of the said hardware accelerator at least one new pair of values to be taken into account to form the said set of pairs of values to be sorted;
- sorting means for the pairs of values, the said sorting means making it possible to perform at least one so-called first-order partial sort assigning the said pairs of values; and

- storage means for the said pairs of values, the said storage means making it possible to store, at a given instant t, the current state of the said sort of the set of pairs of values, on the basis of a so-called second-order partial sort assigning the set of the said pairs of values, in such a way that a single second-order partial sort is sufficient for the said hardware accelerator to deliver at output a pair of values comprising:
- the current minimum error value of the set of error values; and
- the identification value associated with the said minimum error value.

Lastly, the subject of the invention is a mobile radio-communication network base station adapted for communicating with mobile stations of the same network, and a mobile radio-communication network mobile station adapted for communicating with base stations of the same network, comprising a device as defined above.

The invention will be better understood on reading the description which follows, given merely by way of example and with reference to the following drawings in which:

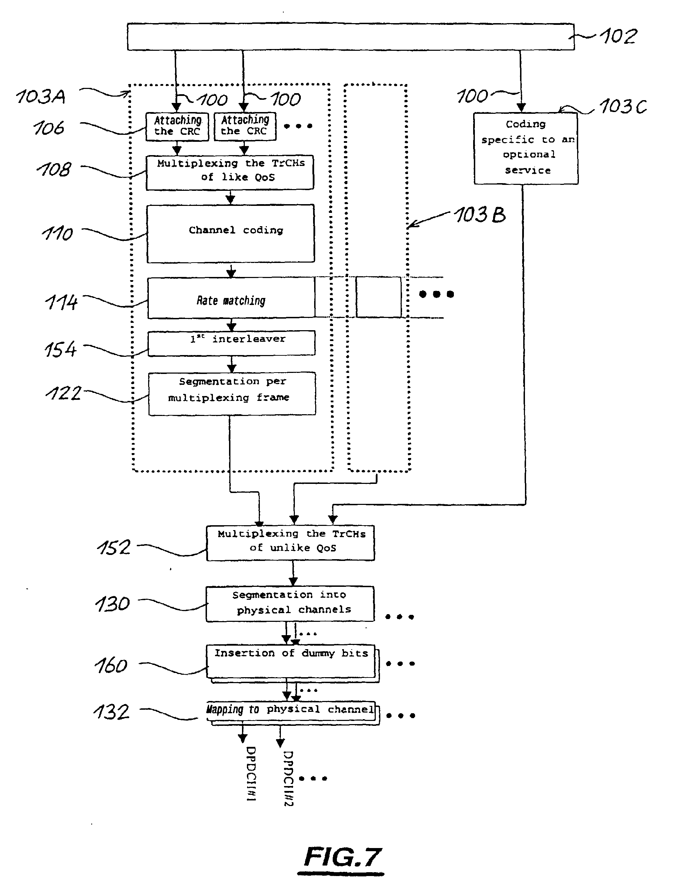

Figure 7 is a diagrammatic view illustrating the multiplexing of the transport channels according to the invention for the downlink;

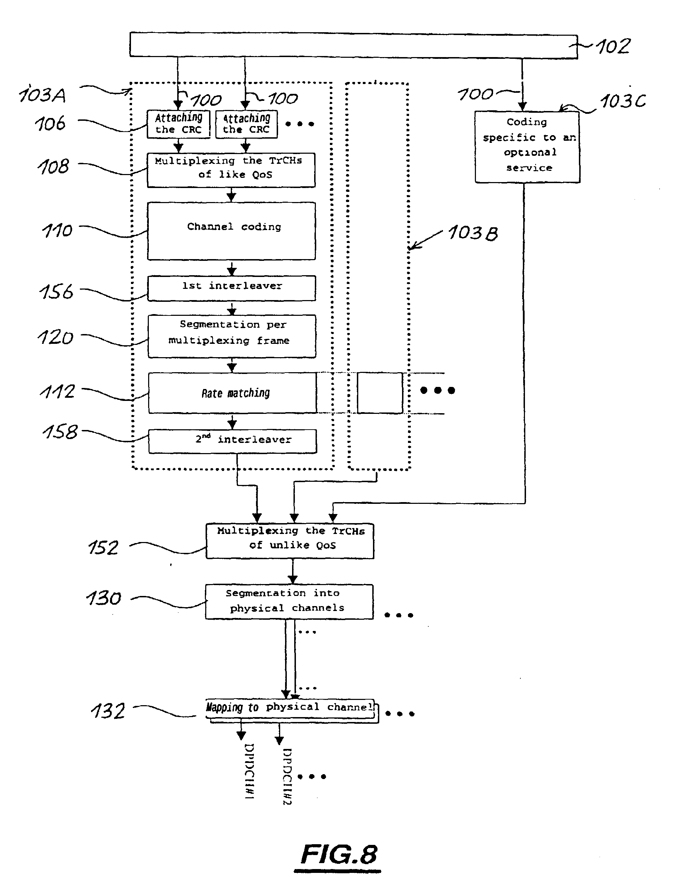

Figure 8 is a diagrammatic view illustrating the multiplexing of the transport channels for the uplink;

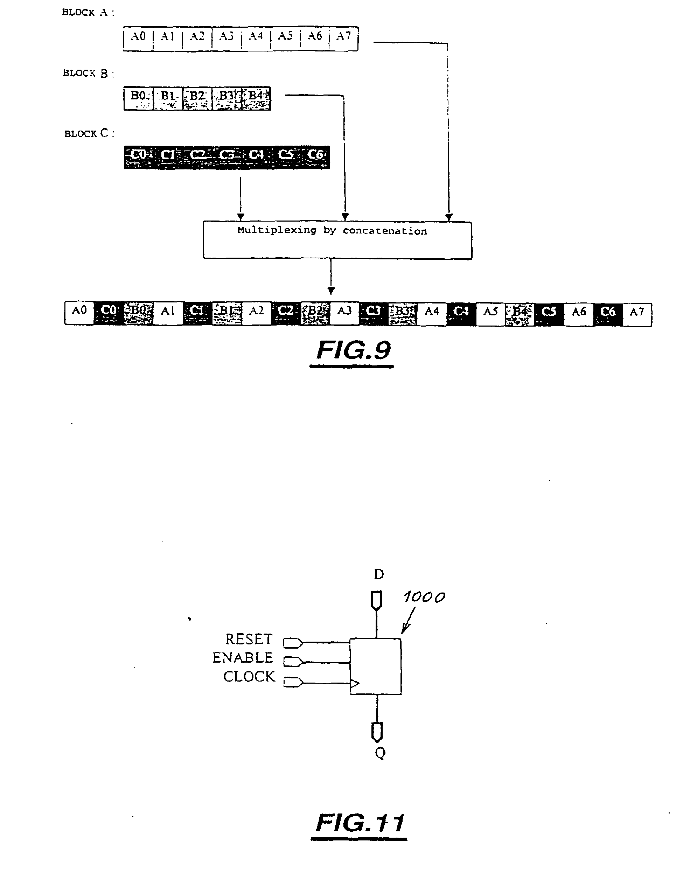

Figure 9 is a diagrammatic view illustrating the multiplexing by shuffling;

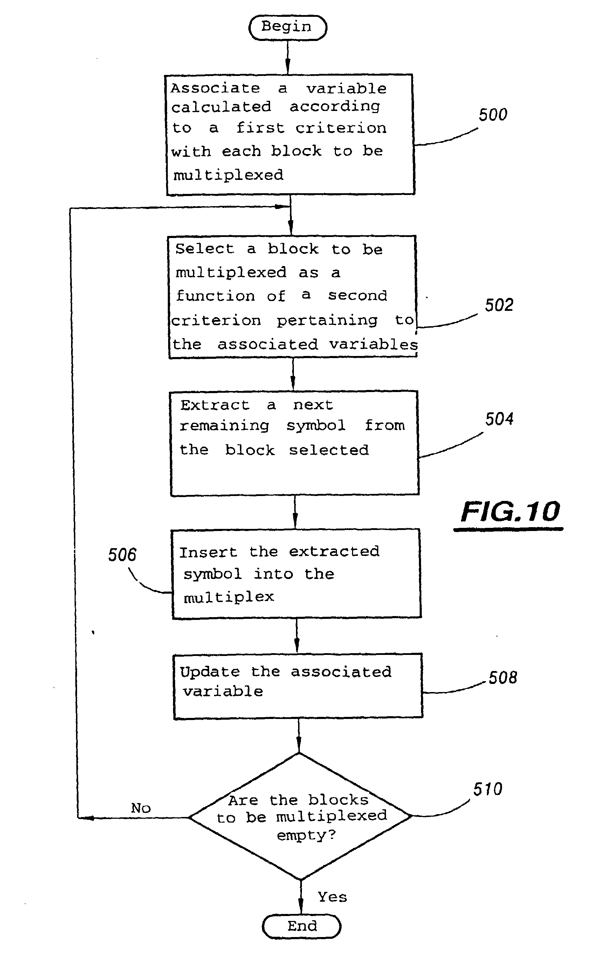

Figure 10 is a flow chart illustrating the implementation of the method of multiplexing by shuffling used;

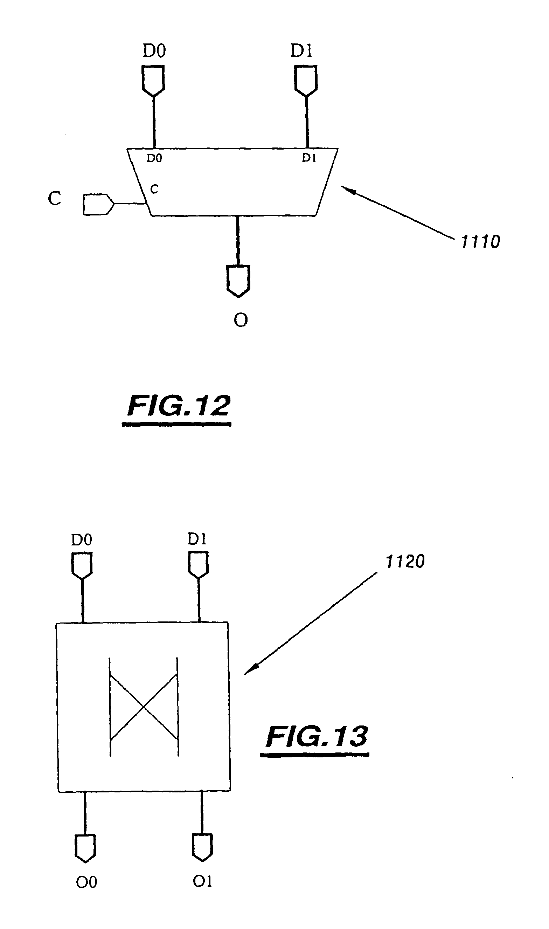

Figure 11 is a diagrammatic view illustrating a memory register;
Figure 12 is a diagrammatic view illustrating a selection gate;

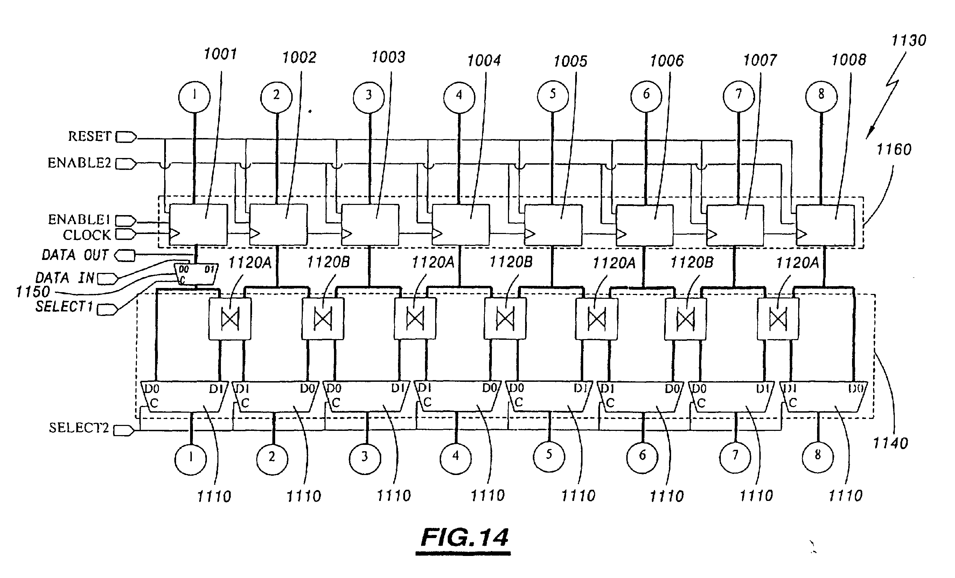

Figure 13 is a diagrammatic view illustrating a sorting gate;
Figure 14 is a diagrammatic view illustrating the hardware accelerator for the "find j such that $e_j = \min \{e_1, e_2 ..., e_8\}$" function;

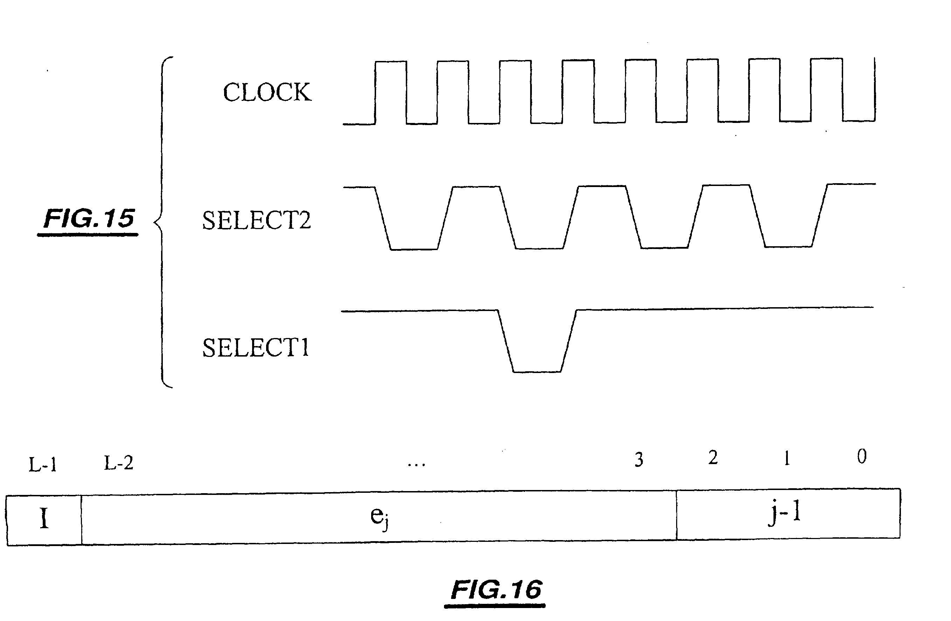

Figure 15 is a diagrammatic view illustrating the waveform of the CLOCK, SELECT2 and SELECT1 signals; and
Figure 16 is a diagrammatic view illustrating the format of the content of the registers.

In the state of the art, the second interleaver 126, 128 of the 3GPP proposal owes its position to the fact that it counteracts the interleaving gain destruction effect of the multiplexing by concatenation 104 of the 3GPP proposal.

According to the invention, and as represented in Figures 7 and 8, the multiplexing 104 by concatenation is replaced by a multiplexing 152 by shuffling.

The introduction of a multiplexing 152 by shuffling makes it possible to eliminate the second interleaver from the downlink and to retain only the first interleaver labelled 154 in Figure 7. In the uplink, the second interleaver 128 located after the multiplexing step 104 is eliminated. Only the first interleaver labelled 156 in Figure 8 remains, to which however has been added a second interleaver 158. However, this second interleaver 158 is provided in each processing chain 103A, 103B upstream of the multiplexing step 152. In the uplink, the interaction between the first 156 and the second interleaver 158 can be dealt with as follows.

The first interleaver 156 is a rectangular interleaver having as many columns as is equal to the ratio of the interleaving time span for the corresponding transport channel(s) to the duration of the multiplexing frame.

For example, if the interleaving time span for the transport channel is equal to 40 ms, and the multiplexing frame corresponds to a radio frame, i.e. 10 ms, the first interleaver 156 is a rectangular interleaver with 4 columns. The segmentation per multiplexing frame 120 is done according to the columns of the first interleaver 156, that is to say the segment corresponding to the $i^{th}$ multiplexing frame in the period over which the transport channel is interleaved corresponds to the $i^{th}$ column of the first interleaver 156.

The first interleaver 156 and the associated segmentation per multiplexing frame 120 may advantageously be replaced by an FS-MIL inter-frame interleaver (Fixed block-Shape Multi-Stage InterLeaver). The method which has already been described is a particular case of the FS-MIL interleaver. The FS-MIL interleaver has been defined by the 3GPP within the current specification referenced S1.12 version 1.1.0.

Table 2 below describes the algorithm for the FS-MIL interleaver.

```
input data:
      N:  integer size of the block to be interleaved and to
          be segmented
      X:  symbol array[0..N-1] - block of symbols to be
          interleaved and to be segmented
      m:  integer -- sequence number of the segment at output,
          m∈{0,1,...,F-1}
      σ:  permutation of {0,1,...,F-1} --
                              permutation of the columns

      Y:  symbol array[0..L-1]- segment, at output we have
```

$$L = \left\lceil \frac{N - \sigma(m)}{F} \right\rceil$$

```
The algorithm is as follows:
      y = σ(m)      --    positions   of   the   symbols   to   be
                                  interleaved
      x: = 0                     -- position in the interleaved
                                  segment at output


      while y<N do
          Y[x] = X[y]      -- interleave a symbol
          x = x + 1        -- next interleaved symbol
          y: = y + F       --      symbol to be interleaved
      end_do
```

Table 2 FS-MIL interleaver followed by segmentation per
multiplexing frame

The interleaver also comprises a matrix having a number of columns which is equal to the number F of multiplexing frames in the time span of an interleaving period for the transport channel(s). The symbols to be interleaved are written into the matrix row-wise. Then the columns are permuted according to a permutation $\sigma$ of {0, 1, ..., F-1}. After permutation, the column in position i is in the position $\sigma^{-1}(i)$. The columns after permutation are therefore the original columns $\sigma(0)$, $\sigma(1)$, ..., $\sigma(F-1)$.

Thus, the order of the symbols in the segments produced is the same as in the input block, thereby making it possible to prevent the puncturing done by the rate matching from interacting unfavourably with the interleaving. In the FS-MIL interleaver described in the current specification S1.12, $\sigma$ is given for the possible values of F in the 3GPP system in the table below:

| F | $(\sigma(0), \sigma(1) ,..., \sigma(F-1))$ |
|---|---|
| 1 | (0) |
| 2 | (0,1) |
| 4 | (0,2,1,3) |
| 8 | (0,4,2,6,1,5,3,7) |

The second interleaver 158 is a rectangular interleaver with dynamically variable depth equal to the integer part of the square root of the size of the block to be interleaved. An algorithm for carrying out this interleaving is given in Table 3.

```
Input data:
       N: size of the block to be interleaved
       X: symbol array[0..N-1] -- block in to be interleaved
       Y: symbol array[0..N-1] -- block out interleaved by the
                                  algorithm
The algorithm is as follows:
       y = 0       -- position of the symbol to be interleaved
       x = 0       -- position of the interleaved symbol
       K = ⌊√N⌋   -- number of columns, ⌊.⌋ notation for the
                     integer part
Ns = ⌊N/K⌋*K      -- size of the largest complete block ≤ N

while x< N do
       Y[x] = X[y]      -- interleaving of a symbol
       x = x + 1        -- next symbol to be interleaved
       if y <N-K then   -- test whether the position  y
                           should be aliased
              y = y + K  -- no aliasing
       else             -- aliasing
              if y ≥ Ns then
                     y = y - (Ns-1)    --    aliasing    in
                                             incomplete
                                             part
              else
                     y = y -(Ns-K-1)   --    aliasing    in
                                             complete part
              end_if

       end_if

       end_do
```

Table   3   Variable-depth   generalized   rectangular interleaver

An alternative algorithm is given in Table 4.

```
Input data:
     N: size of the block to be interleaved
     X: symbol array[0..N-1] -- block in to be interleaved
     Y: symbol array[0..N-1] -- block out interleaved by the
                                         algorithm
The algorithm is as follows:
y = 0               -- position of the symbol to be interleaved
x = 0               -- position of the interleaved symbol
K = ⌊√N⌋            -- number of columns, ⌊.⌋ notation for the
                       integer part
L = ⌊N/K⌋           -- number of complete lines
Ns = L·K            -- size of the largest complete block ≤ N

while x< N do
        Y[y] = X[x]        -- interleaving of a symbol
        x = x + 1          -- next symbol to be interleaved
        if y ≥ (L+1)*(N-Ns) then    -- test whether in the
                                       same column, row L+1
                                       is in its complete
                                       part

            if y ≥ N-L then         -- test whether aliasing
                                       in incomplete part

                y = y -(N-L-1)    -- aliasing

            else

                y = y + L          -- no aliasing

            end_if

        else

            if y ≥ N-L-1 then       -- test whether aliasing
                                       in complete part

                y = y - (N-L-2)        -- aliasing

            else

                y = y + L + 1          -- no aliasing

            end_if

        end_if

    end_ do
```

Table   4   Variable-depth   generalized   rectangular interleaver

These algorithms are simple enough for the interleaving positions to be calculated on the fly, that is to say symbol by symbol. Hence, they require no tabulation, that is to say for example a correspondence table such that the nth element is the position after the interleaving of a symbol in nth position before interleaving.

Let us note that in the case where the interleaving time span for the transport channel is equal to the duration of a multiplexing frame, then the first interleaver 156 and the segmentation 120 would have no effect, and could just as well be omitted.

The combination of the first interleaver 156 and of the segmentation 120 is such that the bits in each segment are in the same order in the segment as in the block before interleaving. Under such conditions, it will be understood that the combination of the first 156 and of the second interleaver 158 can have no destructive effect on the interleaving gain. Moreover, when the rate matching is done by puncturing, as the rate matching algorithm at 112 (Table 1) does not puncture consecutive bits, and as the first interleaver 156 preserves the order restricted to a segment, it follows that neither does the rate matching puncture consecutive bits on exit from the channel coder 110.

Finally, as the first interleaver 156 preserves the order locally to a segment, the rate matching algorithm proceeds by taking the bits in order and by repeating/puncturing according to this order. It is then possible to achieve the first interleaver 156, the rate matching 112 and the second interleaver 158 by calculating the interleaving positions on the fly, as well as the necessity of puncturing/repeating. This allows the maximum possible limitation on reads and writes of symbols in random access memory, this being an appreciable saving of time.

The multiplexing by shuffling at 152 is done according to an algorithm given in Table 5 which draws its inspiration from the rate matching algorithm given in Table 1.

```
Input data:
     X₁ : symbol array[0..N₁-1] -- 1st block to be multiplexed
          ...
     Xᵢ : symbol array[0..Nᵢ-1] -- ith block to be multiplexed
          ...
     Xₚ : symbol array[0..Nₚ-1] -- pth block to be multiplexed
     Y  : symbol array[0..N-1] -- multiplex N = N₁+N₂+...+Nₚ

The algorithm is as follows:
     for i = 1 to p do
     eᵢ = N-Nᵢ    -- initialize error for all the blocks to be
                    multiplexed
     for i = 1 to p do
         Xᵢ = 0  -- initialize position in all the blocks to
                    be multiplexed
         X = 0   -- initialize position in the multiplex
while x < N do
         Find j such that eⱼ = min {e₁, e₂,..., eₚ}
         Y[x] = Xⱼ[xⱼ]      -- multiplex
         x = x + 1
         xⱼ = xⱼ + 1
         If xⱼ = Nⱼ then
              eⱼ = +∞     -- block   j   will   no   longer   be
                              selected
         Else
              eⱼ = eⱼ + 2·(N-Nⱼ)
         End_if
     end_do
```

Table 5 Multiplexing by shuffling

In this algorithm, an error, given by the formula $\frac{e_i}{x \cdot N}$, between the ratios $x_j/x$ and $N_j/N$ is calculated. The block which is selected for the multiplexing is the one for which the error is smallest, since the aim is to minimize the maximum error during the execution of the algorithm. For the algorithm to be fully defined, it is necessary that the operation "find

j such that $e_j$ = min $\{e_1, e_2, ..., e_p\}$" be defined when the minimum is attained at several points. For example, we can define j by the algorithm of Table 6.

```
j: = 1;
i: = 2;
while i≤p do
        If e₁≤ eⱼ then j: = i;
end_do
```

Table 6

Stated otherwise, a lexicographic order relation over the set of pairs $(e_j,i)$ is considered. This relation is such that if $e_i<e_j$ then $(e_i,i)<(e_j,j)$, and if $e_i = e_j$ then if moreover i<j we have $(e_i,i)<(e_j,j)$. Thus, if the values of the errors $e_i$ and $e_j$ are different, then the order of the value pairs $(e_i,i)$ and $(e_j,j)$ is the same as that of the errors $e_i$ and $e_j$. Otherwise the order of the pairs $(e_i,i)$ and $(e_j,j)$ is the same as that of the identification values i and j of the blocks to be multiplexed. The identification value j determined by the operation "find j such that $e_j$ = min$\{e_i,...., e_p\}$" is in fact that for which the pair of values $(e_j,j)$ is the minimum for the lexicographic order of the set of value pairs $\{(e_1,1),..., (e_p,...,p)\}$. This operation would then be better defined as "find j such that $(e_j,j)$ = min $\{(e_1,1),..., (e_p,p)\}$".

The multiplexing by shuffling algorithm implemented in the method according to the invention is illustrated in Figure 10.

Thus, initially, in step 500, a variable ej is associated with each block to be multiplexed. This variable ej is calculated by applying a first evaluation criterion which, here, gives, for the block having the identification value j, the value of the initial error $e_j$ = N - $N_j$ where N is the total length of the multiplex to be obtained and $N_j$ is the number of symbols of block j to be multiplexed. In step 502, one of the blocks to be multiplexed is selected by applying a second evaluation criterion pertaining to the associated variables $e_j$ defined on the basis of the first criterion. In the example considered, the second criterion leads to the selecting, from among all the blocks, of that one the error ej of which is smallest.

In the block thus selected, the next remaining symbol, considered in the direction defined for the extraction of the symbols, is extracted in step 504. This extracted symbol is then inserted at the end of the multiplex undergoing definition in step 506.

With a view to supplementing the multiplex, with another symbol extracted from a block which is not yet empty, the variable associated with the block from which the last symbol has just been extracted is re-updated in step 508.

Steps 502 to 508 are repeated so long as the blocks to be multiplexed are not all empty. This repetition is managed in particular by a test performed in step 510.

The algorithm defining the multiplexing by shuffling can operate on a variable number of blocks of variable size. Also, when the transport channels have variable bit rates, the multiplexer carries out dynamic multiplexing, varying multiplexing frame by multiplexing frame.

By virtue of the multiplexing by shuffling 152, only a single interleaver 154 is needed in the downlink, this interleaver can for example be a rectangular interleaver such as the one given in Table 1. This interleaver 158 has the advantage of having variable depth, and of being able to calculate on the fly, that is to say symbol by symbol.

In a word, the invention, by using a single interleaving method and being able to calculate on the fly the interleaving positions of the interleaved symbols for any depth whatsoever, fits from the outset with the logic of upgradeability and flexibility. Any interleaver having the same characteristics of variable depth and on-the-fly calculation capability could be used in the invention instead of the rectangular interleaver defined in the algorithm of Table 3.

Finally, in the downlink, an insertion of dummy bits 160 is carried out in last place in the invention, between the segmenting of the physical channels 130 and the mapping to physical channel 132. On the other hand, it is recalled that, in the 3GPP proposal, the insertion of dummy bits is carried out before the second interleaver 126. Insertion in last place makes it possible more easily to control the time position of the discontinuous-transmission dummy bits. In particular, it is thus simpler to group them together temporally, so as to have a discontinuous transmission period of significant duration. Keeping the discontinuous-transmission dummy bits makes it possible to arrange for periods during which the mobile station can make measurements on other carrier frequencies, with a view to a possible handover.

In the algorithm defining the multiplexing by shuffling given in Table 5, the limiting step is that of the operation "find j such that $e_j$ = min $\{e_1,e_2,...,e_p\}$" which is defined in Table 6.

The SIEMENS (registered trade mark) algorithm of Table 1 is a particular case of the multiplexing by shuffling algorithm. Thus, in the case of the multiplexing of two blocks only, it is possible to rewrite the algorithm whilst having just a single criterion $e = e_1-e_2$. It is then sufficient to test the sign of e so as to ascertain from which of the two input blocks to read a symbol, this being simpler than searching for the minimum of $e_1$ and $e_2$.

Optimization of the algorithm is also possible when, instead of having a criterion $e_i$ per block i at the input of the shuffling multiplexer, we have such a criterion per possible size $N_i$ of this block. It is therefore sufficient to group together the blocks of like size, as long as there are any, so as to reduce the complexity of the algorithm.

Thus, if for every i from 1 to p, we have $p_i$ blocks $X_{i,1}$, $X_{i,2}$,...$X_{i,pi}$ of size $N_i$, then the new algorithm can be written as in Table 7.

```
Input data for the algorithm:

    X₁,₁: symbol array[0..N_i-1]    --  1ˢᵗ  block   to   be
                                         multiplexed
         ...              ...
    X₁,ₚ₁: symbol array[0..N_i-1]   --  p₁ᵗʰ  block   to   be
                                         multiplexed
    X₂,₁: symbol array[0..N_i-1]    --  (p₁+1)th block  to  be
                                         multiplexed

         ...              ...


    Xₚ,ₚₚ: symbol array[0..N_p-1]   --
```

$$\left(\sum_{i=1}^{i=p} p_i\right)^{th}$$ block to be multiplexed

```
    Y: symbol array [0..N-1]     --  multiplex     N      =
                                     p₁·N₁+p₂.N₂+...+pₚ·N_p
The algorithm is as follows:
    for i = 1 to p do
    e_i = N-N_i   --        initialize the error criterion for
                            all the block sizes
    for i = 1 to p do
        x = 0  -- initialize the position in the multiplex

while x < N do
    find j such that e_j = min {e₁, e₂,..., e_p} see Table 5
    for i: = 1 to p_j do
        Y[x]: = X_{j,i}[x_j]        -- multiplex
        X: = x+1
    end_do
    x_j: = x_j+1
    if x_j = N_j then
        e_j: = +∞   --  the blocks of size N_j will never
                        again be selected
    Else
        e_j = e_j + 2·(N-N_j)
    end_if
end_do
```

Table 7 Multiplexing by shuffling

As an alternative to the software described for performing the operation "find j such that $e_j$ = min {$e_1$, $e_2$,... $e_p$}" of Table 6, it is possible to implement a hardware accelerator 1130. Such a hardware accelerator 1130 is described below in conjunction with Figure 14.

The hardware accelerator 1130 comprises the following means:

- Storage means 1160 comprising memory latch registers 1000. A memory register 1000 is represented in Figure 11. Such a register 1000 comprises four input ports RESET, ENABLE, CLOCK and D, and an output port Q. The D and Q ports are L-bit data ports, whereas the RESET, ENABLE and CLOCK ports are 1-bit control ports. The Q port reflects the current value of the internal state of the register 1000. The D port serves to present a new value for this internal state. The new value is taken into account upon a rising edge of the clock arriving on the CLOCK port when the ENABLE port is active. Thus, the current value of the register 1000 can flip upon a rising edge of the clock. Conversely, while the ENABLE port is in the inactive state, the current value of the internal state of the register 1000 is preserved upon the rising edges of the clock. Finally, the RESET port, when it passes at any instant to the active state, forces the internal state of the register 1000 to be initialized completely to zero. Each of the registers referenced 1001 to 1008 in Figure 14 is identical to the register referenced 1000 in Figure 11.

• Sorting means 1140 comprising elementary sorting gates 1120 and selection gates 1110. The sorting means 1140 are fed by the outputs of the registers 1001 to 1008, through a port DATA_IN which makes it possible to take into account the values of a new triplet $\{l_j, e_j, j\text{-}1\}$, and of input signals labelled SELECT1 and SELECT 2. The input signal SELECT2 is used to define two modes of a so-called first-order partial sort described later. The input signal SELECT1 makes it possible when it is equal to 0, as explained later, to load input values presented on the DATA_IN port.

The sorting means 1140 make it possible to perform a first-order partial sort, at the conclusion of which the content of the registers 1001 to 1008 is not necessarily completely sorted. The result of this first-order partial sort is then fed back into the registers 1001 to 1008. Stated otherwise, each output of the selection gates 1110 is linked to the D input of one of the corresponding registers 1001 to 1008 (link labelled from 1 to 8 in a circle in Figure 14). The first-order partial sort is performed exclusively, according to one of the following two modes, referred to as the first and second modes respectively:

- During the first mode, the input signal SELECT2 is equal to 1, the contents of the register pairs referenced 1001, 1002; 1003, 1004; 1005, 1006 and 1007, 1008 are sorted elementarily in ascending order: for example on concluding the elementary sorting of the content of the register pair referenced 1001, 1002, the smaller value is in the register referenced 1001, and the larger value in the register referenced 1002.
- During the second mode, the input signal SELECT2 is equal to 0, the contents of the register pairs referenced 1002, 1003; 1004, 1005 and 1006, 1007 are sorted elementarily in the same order, namely ascending order.

We consider for example the case where the value of the input signal SELECT2 changes with each clock tick.
A second-order partial sort implementing not only the sorting means 1140, but also the storage means 1000, comprises the succession of a first-order partial sort in the first mode and a first-order partial sort in the second mode. Thus, each register pair assigned by the first-order partial sort in the second mode overlaps two register pairs assigned by the first-order partial sort in the first mode. It will therefore be understood that the second-order partial sort (by alternating the two modes of the first-order partial sort) is not restricted to the content of the register pairs taken separately, but pertains to the entire contents of the registers.
In this way, by implementing the second-order partial sort in a sufficient manner, that is to say as often as the number of registers divided by two, the entire contents of the registers is sorted.
Moreover, when the value of the input signal SELECT1 is equal to 1, the value of the output from the first register referenced 1001 is selected as output from the loading means 1150, and hence as input for the sorting means 1140. Such a selection makes it possible to take into account, during a first clock tick, a new value presented on the DATA_IN port, substituting this for the last value contained in the first register 1001, namely the minimum value of the contents of the registers 1001 to 1008.

• Selection gates 1110. A selection gate 1110 is represented in Figure 12. Such a gate 1110 comprises three input ports C, D0, D1, and an output port 0. The ports D0, D1 and O are L-bit data ports, whilst the port C is a 1-bit control port. The port O takes the value of the port DO when the control port C is at zero, otherwise, C is at 1, and O takes the value of the port D1.

• Sorting gates 1120. A sorting gate 1120 is represented in Figure 13. Such a gate 1120 comprises two input ports D0 and D1, and two output ports O0 and 01. These four ports are L-bit data ports. The ports O0 and O1 respectively take the values of the ports D0 and D1 when D0 is smaller than, or equal to, D1 according to a given order relation. Otherwise, the ports O0 and O1 respectively take the values of D1 and D0. Thus, the two values presented as input to the ports D0, D1 are sorted at the output of the ports O0 and O1.

• Loading means 1150 comprising a selection gate. The loading means 1150 feed the sorting means 1140. The loading means 1150 make it possible, conditioned by the value of the input signal SELECT1, to output either the value of the port DATA_IN (when the input signal SELECT1 is at 0), or the value of the content of the first register 1001 (when the input signal SELECT1 is equal to 1).

The hardware accelerator 1130 of the invention, represented in Figure 14, is capable of performing the function "find j such that $e_j = \min \{e_1, e_2..., e_p\}$" for a number p equal to at most 8 (this number being taken by way of example). In the figure, transfers are represented by pairs of circles bearing a number. Thus the two circles bearing the number 1 are in electrical contact.

The hardware accelerator 1130 will be better understood on considering Figure 15. Via means which are not represented in Figure 14, the signal SELECT2 is made to take the values 0 and 1 alternately at the sampling instants given by the rising edges of the clock signal. Noting that the inputs D0 and D1 are in reverse order from one selection gate 1110 to the next, it will be understood that when the signal SELECT2 is equal to 1 then only the sort performed by the sorting gates 1120A at odd positions (1st, 3rd, etc. ...) is taken into account so as to update the value of the latch registers 1000. When the signal SELECT2 is equal to 0, the reverse holds, thus the sort performed by the sorting gates 1120B at even positions (2nd, 4th, etc. ...) is taken into account.

With such a layout, it will be understood that if moreover the signal SELECT1 is equal to 1, the signals ENABLE1 and ENABLE2 are equal to 1, and the signal RESET is equal to zero, while the contents of the registers end up being sorted in such a way that the values increase from left to right in Figure 14.

The format of the content of a register 1000 is represented in Figure 16. It comprises:

- an indicator of the value of j of the bits 0 to 2 ($2^3 = 8$ is the value for p in our example);
- an indicator of the value of $e_j$ of the bits 3 to L-2. This indicator is relevant when $e_j \neq +\infty$, arbitrary otherwise; and
- a bit l at 1 when $e_j \neq +\infty$, and at zero otherwise.

Thus, the format of the content of the registers 1001 to 1008 makes it possible essentially to distinguish between two items of information:

- an indicator j identifying the block to be selected; and
- an error value ($l_j$, $e_j$) allowing selection.

This error value can have an infinite value ($l_j = 1$) so that block j is no longer selected when all its symbols have been appended to the multiplex under formation, or finite ($l_j = 0$) when there are still symbols in block j which are not yet in the multiplex under formation.

In the embodiment described here, a specific bit ($l_j$, bit L-1) serves to mark the infinite value. Thus, in Tables 5 and 7, the operation "$e_j$: = $+\infty$" amounts to setting this specific bit to 1, whilst during the operations "$e_j$: = N-N$_j$" and "$e_j$: = $e_j$+2.(N-N$_j$)" this specific bit is set to zero, and the value is loaded into bits 3 to L-2.

In another embodiment, there is no specific bit $l_j$ to mark the infinite value, and the finite or infinite value of ej is stored in bits 3 to L-1. On the other hand, there is a certain threshold labelled max, such that $e_j$ is regarded as finite when $e_j \leq max$, and as infinite for any value such that $e_j > max$. To this end, the number of bits L-3 over which $e_j$ finite or infinite is preserved is sufficient to keep the value max+1. Moreover, the threshold max is such that it is never exceeded when ej is updated by the operations "$e_j$:=N-N$_j$" and "$e_j$: = $e_j$+2.(N-N$_j$)" of Tables 5 and 7, and the operation "$e_j$: = $+\infty$" amounts to storing a larger value than max, for example max+1 or else ($2^{L-3}-1$).

Thus the canonical order over the natural integers, applied to the contents of the registers 1000, is sufficient to perform the desired sort so as to obtain the function "find j such that $e_j = \min \{e_1,e_2, ... ,e_p\}$".

The hardware accelerator 1130 operates as follows:

Firstly, all the registers 1000 are reset to zero with the aid of the RESET port. During normal functioning, the RESET input remains at zero, that is to say in an inactive state.

When the signal SELECT1 is at 1, the sort is performed on the existing values of the ($l_j$,$e_j$,j-1), otherwise, the signal SELECT1 can be set to zero when the signal SELECT2 itself also takes the value zero, this making it possible to change the value in the first register by presenting a new value on the DATA_IN port. Thus all the registers may be initialized by loading the values {0,N-Ni,i-1} for i=1 to p into the first register at most every second clock pulse (or tick). As the initial values are necessarily non-zero since, for any i, we have N-N$_i \neq$0, then as long as all the registers 1001 to 1008 have not been loaded, after two clock ticks, one of the zero values given initially to the "reset" will be dropped back down into the first register and may be overwritten by the next value of {0,N-N$_i$, i-1}.

When the p values have been loaded in this way, it is sufficient to read, on the DATA_OUT port, the value of j in the three least significant bits. This value is the one which satisfies $e_j = \min \{e_1...,e_8\}$. After having incremented the value $e_j$ by 2(N-N$_j$), or having set it to $+\infty$, the new value of the triplet {$l_j$,$e_j$,j-1} can be reloaded into the first register, by presenting this value on the DATA_IN port, by setting the signal SELECT1 to zero when the signal SELECT2 also goes to zero. After two clock ticks afterwards, the new value of j given by the function "find j such that $e_j = \min \{e_1, e_2,... e_p\}$" can be read on the DATA_OUT port.

It is important to note that the only constraint to be observed, to obtain optimal functioning of the hardware accelerator described, lies in the fact that between two zeroings of the input signal SELECT1, the input signal SELECT2 must have changed value at least twice.

Thus, assuming that the input signal SELECT2 changes value with each clock tick and that the registers 1001 to 1008 have already been loaded, then after having presented a new triplet $\{l_j, e_j, j\}$ on the DATA_IN port by setting the input signal SELECT1 to zero, two clock ticks are sufficient in order for the value of the minimum error $e_j$ to be dropped back down, within the first register 1001, together with the associated values of j and $l_j$. Thus, by presupposing in this example that the input signal SELECT1 takes the value 0 only on the same clock ticks for which the input signal SELECT2 is equal to zero, it is guaranteed that between two zeroings of the input signal SELECT1, the input signal SELECT2 has twice changed value. Thus, after having presented a new $\{l_j, e_j, j\}$ by setting the input signal SELECT1 to zero, a second-order partial sort starting at the same moment is sufficient to obtain the minimum triplet $\{l_j, e_j, j\}$ on the DATA_OUT port.

In another embodiment, the same result could be obtained by presupposing that the input signal SELECT1 has the value 0 only on the clock ticks for which SELECT2 is equal to 1. In this case, the second-order partial sort would be defined by firstly doing a first-order partial sort in the second mode, and thereafter a first-order partial sort in the first mode.

A crucial point in the performance of this device is that there is no need for the values of all the registers to be completely sorted. It is sufficient to be certain that the content of the first register is the minimum of all of them. Thus, the sort may be carried out in parallel with the multiplexing. This is because there is no need to wait for the new value of the triplet $\{l_j, e_j, j-1\}$ after incrementation by $2(N-N_j)$, or setting to $+\infty$, to be propagated to what would be the definitive position if we had waited for the sort to be carried out completely. Two clock ticks are sufficient for the incremented value to be propagated far enough for the value in the first register to be the minimum.

Thus, if the algorithm were performed at the fastest possible speed with the hardware accelerator 1130 described, the signals SELECT1 and SELECT2 would still have the same value, the value of j such that $e_j = \min \{e_1, ..., e_p\}$ would be read on the DATA_OUT port when the signal SELECT1 is equal to 1, and the incremented value of the triplet $\{l_j, e_j, j-1\}$ read would be written when the signal SELECT1 had gone to 0. Moreover, a cue which makes it possible to demultiplex and decode a multiplexing frame so as to obtain the transport channels is referred to as a combination of transport formats. This cue can be transmitted explicitly multiplexing frame by multiplexing frame. This is referred to as explicit bit rate detection.

Another so-called implicit method consists in not forwarding this cue. The receiver of the multiplexing frame must then try all the possible transport format combinations until the test of the CRC word attached to the transport block is positive for at least a certain number of transport blocks.

Given that the transport channels do not all have the same transmission interval, the CRC words of the transport blocks of a transport channel having a transmission interval equal to several multiplexing frames can only be tested after these multiplexing frames have been completely received.

Now, the multiplexing is done multiplexing frame by multiplexing frame according to the combination of transport formats.

It is therefore simpler when this multiplexing does not depend on the combination of transport formats. This can be achieved by inserting discontinuous transmission dummy bits before the multiplexer 152 of transport channels with different qualities of service (QoS) so that the multiplexed blocks have a constant size.

Thus, it is possible, through minor modifications to the method, to use the same coding, interleaving and multiplexing means in the network when the method implemented is implicit bit rate detection or explicit bit rate detection.

**Claims**

1. Method for interleaving and multiplexing data conveyed within several transport channels (100) distributed into groups of transport channels, the transport channels of one and the same group all having the same quality of service, in which method the data of the transport channels of one and the same group are processed using one and the same processing procedure (103A, 103B) specific to the group of transport channels, each processing procedure (103A, 103B) comprising at least one data interleaving step (154; 156, 158), and in which a multiplexing step (152) is provided at the conclusion of the processing procedures (103A, 103B), characterized in that the said multiplexing step (152) on exiting the said processing procedures (103A, 103B) is a multiplexing by shuffling, and in that all the said data interleaving steps (154; 156, 158) are implemented within the said processing procedures (103A, 103B).

2. Method according to Claim 1 for transmission along an uplink from a mobile station to a fixed network, characterized in that each processing procedure (103A, 103B) implements first and second interleaving steps (156, 158) operating in succession.

3. Method according to Claim 2, characterized in that the said second interleaving step (158) comprises a rectangular interleaving step with dynamically variable depth.

4. Method according to Claim 2 or 3, for transmission along an uplink from a mobile station to a fixed network, characterized in that a single rate matching step (112) is provided within each processing procedure (103A, 103B) between the said first and second interleaving steps (156, 158).

5. Method according to Claim 4, characterized in that the said first interleaving step (156) comprises an initial step of writing symbols along the rows of a matrix, the number of columns of which is equal to the number of multiplexing frames which can be processed during the said step of multiplexing by shuffling (152) in the time span necessary for the said first interleaving step (156), and a subsequent step of reading symbols along the columns of the matrix for obtaining blocks of interleaved symbols, and in that the blocks of interleaved symbols obtained following the implementation of the said first interleaving step (156) are segmented so that each segment corresponds to a column of the said matrix, the said rate matching step (112) being implemented on each of the said segments.

6. Method according to Claim 1, for transmission along a downlink from a fixed network to a mobile station, characterized in that it comprises a single interleaving step (154) in each processing procedure (103A, 103B).

7. Method according to Claim 1 or Claim 6, for transmission along a downlink from a fixed network to a mobile station, characterized in that it comprises, after the said step of multiplexing by shuffling (152), a step of inserting dummy bits (160).

8. Method according to any of Claims 1, 6 or 7, for transmission along a downlink from a fixed network to a mobile station, characterized in that a rate matching step (114) is implemented for each processing procedure (103A, 103B), with a static rate matching ratio.

9. Method according to any of the preceding claims, characterized in that the said step of multiplexing by shuffling (152) initially comprises a step consisting in associating, with each block to be multiplexed, a variable obtained by applying a first evaluation criterion, then, for the construction of the multiplex, the following steps, repeated iteratively for all the symbols to be multiplexed:

   e) selecting, as a function of a second evaluation criterion pertaining to the said associated variables, one of the blocks to be multiplexed;
   f) extracting from the selected block the next remaining symbol when considering a given order of reading in the selected block;
   g) inserting the extracted symbol at the end of the multiplex; and
   h) re-updating the variable associated with the selected block.

10. Method according to any of the dependent claims, characterized in that the said step of multiplexing by shuffling (152) is implemented on data blocks the number and size of which vary dynamically from one multiplexing frame to the next.

11. Method according to any of the preceding claims, characterized in that it is implemented within a radio-communication system implementing CDMA technology.

12. Device for interleaving and multiplexing data conveyed within several transport channels (100) distributed into groups of transport channels, the transport channels of one and the same group all having the same quality of service, comprising:

   - a processing chain (103A, 103B) specific to each group of transport channels, allowing the processing of the data of the transport channels of one and the same group, each processing chain (103A, 103B) comprising at least data interleaving means (154; 156, 158), and
   - multiplexing means (152) provided at the output of the processing chains (103A, 103B),

   characterized in that the said multiplexing means (152) provided at the output of the processing chains (103A, 103B) are means of multiplexing by shuffling, and in that all the data interleaving means (154; 156, 158) are included within the said processing chains (103A, 103B).

**13.** Device according to Claim 12, characterized in that the said means of multiplexing by shuffling comprise a hardware accelerator (1130) making it possible to perform a sort of a set of pairs of values comprising, for each of the said pairs, at least:

- an identification value (j) for a class of data blocks having an identical size of data blocks; and
- an error value $(l_j,e_j)$ associated with each class of data blocks, the said error value $(l_j, e_j)$ making it possible to select, iteratively, from among the classes of data blocks to be multiplexed, the class of data blocks the symbols of which are to be appended to the multiplex undergoing formation;

the said hardware accelerator (1130) comprising:

- loading means (1150) for the said pairs of values, the said loading means (1150) making it possible to load into the input (DATA_IN) of the said hardware accelerator (1130) at least one new pair of values $((l_j,e_j),j)$ to be taken into account to form the said set of pairs of values to be sorted;
- sorting means (1140) for the pairs of values $((l_j,e_j),j)$, the said sorting means making it possible to perform at least one so-called first-order partial sort assigning the said pairs of values; and
- storage means (1160) for the said pairs of values, the said storage means (1160) making it possible to store, at a given instant (t), the current state of the said sort of the set of pairs of values, on the basis of a so-called second-order partial sort assigning the set of the said pairs of values,

in such a way that a single second-order partial sort is sufficient for the said hardware accelerator (1130) to deliver at output (DATA_OUT) a pair of values comprising:

- the current minimum error value (lj,ej) of the set of error values; and
- the identification value (j) associated with the said minimum error value $(l_j,e_j)$.

**14.** Mobile radio-communication network base station adapted for communicating with mobile stations of the same network, characterized in that it comprises a device according to Claim 12 or 13.

**15.** Mobile radio-communication network mobile station adapted for communicating with base stations of the same network, characterized in that it comprises a device according to Claim 12 or 13.

Row-wise filling

02A

04A

Column-wise emptying

02B

04B

*FIG.1*

*FIG.2*

102

103A

100    100

106  Attaching the CRC    Attaching the CRC    • • •

100    103C

Coding specific to an optional service

108  Multiplexing the TrCHs of like QoS

110  Channel coding

103B

116  1st interleaver    • • •

120  Segmentation per multiplexing frame

112  Rate matching

104  Multiplexing the TrCHs of unlike QoS

130  Segmentation into physical channels    • • •

128  2nd interleaver    • • •

132  Mapping to physical channel    • • •

DPDCH#1    DPDCH#2    • • •

*FIG.3*

**_FIG.4_**

BLOCK A :

| A0 | A1 | A2 | A3 | A4 | A5 | A6 | A7 |

BLOCK B :

| B0 | B1 | B2 | B3 | B4 |

BLOCK C :

| C0 | C1 | C2 | C3 | C4 | C5 | C6 |

Multiplexing by concatenation

| A0 | A1 | A2 | A3 | A4 | A5 | A6 | A7 | B0 | B1 | B2 | B3 | B4 | C0 | C1 | C2 | C3 | C4 | C5 | C6 |

## _FIG.5_

Transport channel A :

| A0 | A1 | A2 | A3 | A4 | A5 | A6 | A7 | A8 | A9 | A10 | A11 | A12 | . . .

. . . | A13 | A14 | A15 | A16 | A17 | A18 | A19 | A20 | A21 |

Transport channel B :

| B0 | B1 |

Multiplexing by concatenation

| A0 | A1 | A2 | A3 | A4 | A5 | A6 | A7 | A8 | A9 | A10 | A11 | A12 | . . .

. . . | A13 | A14 | A15 | A16 | A17 | A18 | A19 | A20 | A21 | B0 | B1 |

4 × 6 rectangular interleaver

| A0 | A6 | A12 | A18 | A1 | A7 | A13 | A19 | A2 | A8 | A14 | A20 | A3 | . . .

. . . | A9 | A15 | A21 | A4 | A10 | A16 | B0 | A5 | A11 | A17 | B1 |

## _FIG.6_

24

**FIG.7**

103A

106 → Attaching the CRC    Attaching the CRC    · · ·    700    700    100

700 → Coding specific to an optional service    103C

108 → Multiplexing the TrCHs of like QoS

110 → Channel coding

103B

156 → 1st interleaver

120 → Segmentation per multiplexing frame

112 → Rate matching    · · ·

158 → 2nd interleaver

152 → Multiplexing the TrCHs of unlike QoS

130 → Segmentation into physical channels    · · ·

132 → Mapping to physical channel    · · ·

DPDCH#1    DPDCH#2    · · ·

## FIG.8

BLOCK A :

| A0 | A1 | A2 | A3 | A4 | A5 | A6 | A7 |

BLOCK B :

| B0 | B1 | B2 | B3 | B4 |

BLOCK C :

| C0 | C1 | C2 | C3 | C4 | C5 | C6 |

Multiplexing by concatenation

| A0 | C0 | B0 | A1 | C1 | B1 | A2 | C2 | B2 | A3 | C3 | B3 | A4 | C4 | A5 | B4 | C5 | A6 | C6 | A7 |

## FIG.9

D

RESET
ENABLE
CLOCK

1000

Q

## FIG.11

```
                          ( Begin )
                              │
                              ▼
              ┌───────────────────────────────┐
              │ Associate  a   variable        │
              │ calculated  according          │
              │ to  a  first criterion         │─── 500
              │ with each block to be          │
              │ multiplexed                    │
              └───────────────────────────────┘
                              │
    ┌─────────────────────────┤
    │                         ▼
    │         ┌───────────────────────────────┐
    │         │ Select a block to be          │
    │         │ multiplexed as a              │
    │         │ function of a  second         │─── 502
    │         │ criterion  pertaining  to     │
    │         │ the  associated variables     │
    │         └───────────────────────────────┘
    │                         │
    │                         ▼
    │         ┌───────────────────────────────┐
    │         │ Extract  a  next              │
    │         │ remaining  symbol  from       │─── 504
    │         │ the  block  selected          │
    │         └───────────────────────────────┘
    │                         │
    │                         ▼                      FIG.10
    │         ┌───────────────────────────────┐
    │  506    │ Insert the extracted          │
    │         │ symbol into the               │
    │         │ multiplex                     │
    │         └───────────────────────────────┘
    │                         │
    │                         ▼
    │         ┌───────────────────────────────┐
    │         │ Update the associated         │─── 508
    │         │ variable                      │
    │         └───────────────────────────────┘
    │                         │
    │                         ▼
    │                      ◇────────◇
    │   No              ◇  Are the blocks ◇ ─── 510
    └──────────────────◇ to be multiplexed ◇
                        ◇    empty?       ◇
                          ◇────────◇
                              │ Yes
                              ▼
                          ( End )
```

_FIG.10_

28

D0    D1

D0    D1

C    C

1110

O

**_FIG.12_**

D0    D1

1120

O0    O1

**_FIG.13_**

FIG.14

**_FIG.15_**

CLOCK

SELECT2

SELECT1

| L-1 | L-2 | ... | 3 | 2 | 1 | 0 |
|:---:|:---:|:---:|:---:|:---:|:---:|:---:|
| I | $e_j$ | | | j-1 | | |

**_FIG.16_**

**European Patent Office**

**EUROPEAN SEARCH REPORT**

Application Number

EP 00 40 0952

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 564 339 A (MATRA COMMUNICATION) 6 October 1993 (1993-10-06) * page 2, line 45 - line 50 * * page 5, line 31 - line 33 * * page 7, line 19 - line 21 * | 1,2,6, 12,14,15 | H03M13/27 |
| A | | 3-5, 7-11,13 | |
| A | US 3 794 768 A (CARNEY A ET AL) 26 February 1974 (1974-02-26) * column 1, line 31 - line 34 * * column 2, line 59 - line 61 * * figure 1 * | 1-15 | |
| A | US 4 460 993 A (HAMPTON DEAN A ET AL) 17 July 1984 (1984-07-17) * column 1, line 30 - line 36 * | 1-15 | |
| A | US 3 749 839 A (FORNASIERO P ET AL) 31 July 1973 (1973-07-31) * column 1, line 22 - line 42 * | 1-15 | TECHNICAL FIELDS SEARCHED (Int.Cl.7) H03M H04J |

The present search report has been drawn up for all claims

| Place of search | Date of completion of the search | Examiner |
|---|---|---|
| THE HAGUE | 29 June 2000 | Orozco Roura, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 00 40 0952

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2000

| Patent document cited in search report | | Publication date | Patent family member(s) | | Publication date |
|---|---|---|---|---|---|
| EP 0564339 | A | 06-10-1993 | FR | 2689346 A | 01-10-1993 |
| | | | AT | 161375 T | 15-01-1998 |
| | | | CA | 2092893 A | 01-10-1993 |
| | | | DE | 69315732 D | 29-01-1998 |
| | | | DE | 69315732 T | 16-07-1998 |
| | | | FI | 931441 A | 01-10-1993 |
| | | | US | 5398247 A | 14-03-1995 |
| US 3794768 | A | 26-02-1974 | AU | 5594573 A | 21-11-1974 |
| | | | BE | 799955 A | 17-09-1973 |
| | | | CA | 1009390 A | 26-04-1977 |
| | | | CH | 564890 A | 31-07-1975 |
| | | | DE | 2325854 A | 13-12-1973 |
| | | | ES | 415116 A | 16-02-1976 |
| | | | FI | 58416 B | 30-09-1980 |
| | | | FR | 2185900 A | 04-01-1974 |
| | | | GB | 1438581 A | 09-06-1976 |
| | | | IT | 1016502 B | 20-06-1977 |
| | | | JP | 1185754 C | 20-01-1984 |
| | | | JP | 49062017 A | 15-06-1974 |
| | | | JP | 58012775 B | 10-03-1983 |
| | | | NL | 7307264 A | 27-11-1973 |
| | | | SE | 381969 B | 22-12-1975 |
| | | | US | RE29215 E | 10-05-1977 |
| US 4460993 | A | 17-07-1984 | CA | 1184324 A | 19-03-1985 |
| | | | DE | 3272495 D | 18-09-1986 |
| | | | EP | 0068595 A | 05-01-1983 |
| | | | JP | 4034340 B | 05-06-1992 |
| | | | JP | 57502243 T | 16-12-1982 |
| | | | WO | 8202465 A | 22-07-1982 |
| US 3749839 | A | 31-07-1973 | AU | 461809 B | 05-06-1975 |
| | | | AU | 3724371 A | 28-06-1973 |
| | | | BE | 772227 A | 17-01-1972 |
| | | | CA | 953441 A | 20-08-1974 |
| | | | CH | 541260 A | 15-10-1973 |
| | | | DE | 2161203 A | 13-07-1972 |
| | | | ES | 392199 A | 01-02-1974 |
| | | | FR | 2118888 A | 04-08-1972 |
| | | | GB | 1331547 A | 26-09-1973 |
| | | | NL | 7117843 A | 27-06-1972 |
| | | | SE | 380151 B | 27-10-1975 |

EPO FORM P0459

For more details about this annex : see Official Journal of the European Patent Office, No. 12/82